# FASCICULE DE BREVET EUROPEEN

(11) **EP 3 002 789 B1**
(45) Date de publication et mention de la délivrance du brevet: **24.04.2019**
(21) Numéro de dépôt: 15187232.2
(22) Date de dépôt: 28.09.2015
(51) Int. Cl.: H01L 27/12, H01L 27/06, H01L 21/265, H01L 21/02, H01L 23/552, H01L 31/18, H01L 31/054, H01L 21/762

(54) **PROCEDE DE RECUIT LOCALISE D'ELEMENTS SEMI-CONDUCTEURS A L'AIDE D'UNE ZONE REFLECTRICE**
LOKALISIERTES GLÜHVERFAHREN VON HALBLEITERELEMENTEN MIT HILFE EINER REFLEKTIERENDEN ZONE
METHOD FOR LOCALISED ANNEALING OF SEMICONDUCTOR ELEMENTS BY MEANS OF A REFLECTING AREA

(30) Priorité: 30.09.2014 FR 1459285
(43) Date de publication de la demande: 06.04.2016
(73) Titulaire: Commissariat à l'Énergie Atomique et aux Énergies Alternatives, 75015 Paris (FR)
(72) Inventeur: OUERGHI, Issam, 38100 GRENOBLE (FR); ERNST, Thomas, 38210 MORETTE (FR); GRENOUILLET, Laurent, 38000 GRENOBLE (FR)
(74) Mandataire: Brevalex

(56) Documents cités:
- JP-A- 2003 289 080
- US-A1- 2007 155 102
- US-A1- 2013 241 026
- US-B1- 8 803 206

## Description

### DOMAINE TECHNIQUE ET ART ANTÉRIEUR

La présente invention a trait au domaine de la réalisation de structures à base de matériau semi-conducteur.

Pour modifier l'arrangement atomique d'un matériau semi-conducteur et effectuer par exemple une cristallisation ou une recristallisation du matériau semi-conducteur ou même une activation de dopants dans ce matériau, il est connu d'effectuer un recuit thermique en exposant ce matériau à un rayonnement par exemple de type laser.

Dans le cas d'un matériau au moins partiellement amorphe et comportant des dopants, la cristallisation et l'activation de dopants peuvent être réalisées en un même recuit.

Un recuit par traitement laser a pour avantage d'être localisé, de sorte que la montée en température du matériau semi-conducteur peut être effectuée tout en limitant l'échauffement de couches situées à proximité de, et en particulier sous ce matériau.

Cette méthode de recuit est employée par exemple lors de la mise en oeuvre de transistors TFT (pour « Thin Film Transistor ») sur un substrat, souvent à base de verre, pour fabriquer des écrans ou intervient par exemple dans la fabrication de cellules solaires.

Le recuit laser permet alors de limiter le budget thermique auquel le substrat est soumis. Un transfert de chaleur aux couches sous-jacentes est toutefois la plupart du temps inévitable.

Pour limiter l'échauffement de couches situées sous une couche de silicium amorphe que l'on doit recristalliser, il est connu de prévoir cette couche de silicium avec une épaisseur suffisamment importante pour permettre une absorption du faisceau laser.

Par ailleurs, lorsque le matériau semi-conducteur à recristalliser est du Si et que la source laser est choisie dans le domaine du rayonnement UV, un transfert de chaleur du Si vers des couches sous-jacentes est limité du fait des bonnes propriétés d'absorption du Si dans cette gamme de longueurs d'ondes.

Malgré ces techniques, la modification de l'arrangement atomique de couches semi-conductrices de faible épaisseur pose problème.

Le document "Thermal Accumulation Improvement for Fabrication Manufacturing of Monolithic 3D Integrated Circuits", de Liu et al., IEEE ICSICT, 2008, présente une solution au problème d'échauffement des couches sous-jacentes à une couche semi-conductrice que l'on souhaite recristalliser.

Elle consiste à introduire une couche de cuivre entre la couche à recristalliser et un substrat sur lequel la couche semi-conductrice amorphe repose. Grâce à une importante conductivité thermique du cuivre, la chaleur est dispersée dans le plan de la couche de cuivre ce qui permet d'éviter une propagation de chaleur dans des couches sous-jacentes.

Un tel procédé pose toutefois des problèmes de rendement énergétique dans la mesure où l'énergie thermique absorbée par le cuivre est perdue. Par ailleurs, avec une telle solution, un système d'évacuation de la chaleur peut s'avérer nécessaire.

En outre, avec cette méthode, le cuivre peut avoir tendance à se dégrader dès lors que la température de recuit excède un seuil de l'ordre de 300 °C.

Les documents US2013/0241026 A1 et US8803206 B1 divulguent des méthodes de rayonnement employant une couche réfléchissante conductrice.

Il se pose le problème de trouver un nouveau procédé qui ne comporte pas les inconvénients ci-dessus et permette de modifier l'arrangement atomique d'un ou plusieurs éléments à base de matériau semi-conducteur et qui sont disposés sur un support, et ce, sans détériorer un ou plusieurs composants disposés sous ces éléments.

### EXPOSÉ DE L'INVENTION

La présente invention se propose de résoudre les problèmes évoqués ci-dessus, en prévoyant d'intégrer une zone réfléchissante sur un support sur lequel se trouvent un ou plusieurs éléments semi-conducteurs destinés à être exposés à une source laser, en particulier pour effectuer un recuit de cristallisation ou recristallisation du ou des éléments semi-conducteurs et/ou une activation de dopants dans le ou les éléments semi-conducteurs, la zone réfléchissante étant configurée de manière à réfléchir un rayonnement lumineux provenant de la source laser.

La zone de protection réfléchissante est un cristal photonique avantageusement de type miroir de Bragg, ou formant un réseau en deux dimensions ou en 3 dimensions.

Lorsque la zone de protection réfléchissante est formée d'un empilement de couches réalisant un miroir de Bragg, une réflectivité importante supérieure à 95% peut être obtenue.

Le miroir de Bragg peut être formé d'un empilement comportant une alternance de couches à base au moins d'un premier matériau diélectrique et de couches à base d'au moins d'un deuxième matériau diélectrique.

Avec une zone de protection réfléchissante non métallique on évite d'éventuels courants de fuites et la création de capacités parasites.

Une zone de protection réfléchissante en matériau diélectrique présente une plus faible conductivité thermique par rapport à une zone de métal, ce qui permet une meilleur conservation de la chaleur au sein de l'élément ou les éléments semi-conducteurs irradiés.

La zone de protection réfléchissante est en outre agencée sur le support par rapport aux éléments et à un ou plusieurs composants intégrés au support de sorte à réaliser une protection des composants vis-à-vis du rayonnement lumineux.

On entend par « composant » un élément actif, cet élément actif pouvant être électronique (par exemple un transistor, une mémoire) ou électromécanique (tel que par exemple un capteur MEMS) ou photonique (tel que par exemple un dispositif émetteur de rayonnement lumineux). Le terme composant recouvre ici également un élément passif tel que par exemple une interconnexion, un guide d'onde, un plan de masse, un réflecteur, un inductance, une capacité.

Un mode de réalisation de la présente invention prévoit un procédé de modification de l'arrangement atomique d'éléments semi-conducteurs par recuit, comprenant des étapes consistant à :
a) prévoir un support comportant un ou plusieurs éléments semi-conducteurs dont on veut modifier l'arrangement atomique, le support étant doté en outre d'un ou plusieurs composants et d'au moins une zone de protection réfléchissante configurée de manière à réfléchir un rayonnement lumineux dans une gamme de longueur d'ondes donnée, la zone de protection étant formée d'un empilement comportant une alternance de couches à base d'au moins un premier matériau diélectrique et de couches à base d'au moins un deuxième matériau diélectrique,
b) exposer le ou les éléments à un rayonnement émettant dans ladite gamme de longueurs d'ondes donnée de manière à effectuer un recuit de(s)dit(s) élément(s), la zone de protection réfléchissante étant un cristal photonique et agencée sur le support par rapport au(x)dit(s) élément(s) et au(x) composant(s) de manière à réfléchir le rayonnement et protéger le ou les composants de ce rayonnement, tout en permettant l'exposition du ou des éléments au rayonnement.

La source de rayonnement utilisée est avantageusement un laser. Un recuit localisé peut être ainsi mis en oeuvre.

La Gamme de longueur d'onde utilisée est adaptée au matériau semi-conducteur des éléments pour permettre de modifier l'agencement atomique du matériau semi-conducteur à base duquel ils sont formés.

Par zone réfléchissante, on entend en particulier une zone ayant une réflectivité d'au moins 70% dans la gamme de longueur d'onde considérée. La zone de protection peut avantageusement être configurée pour réfléchir au moins 90% du rayonnement lumineux.

Selon une possibilité de mise en oeuvre de ce procédé, la modification de l'arrangement atomique des éléments semi-conducteurs comprend une cristallisation ou recristallisation d'un matériau semi-conducteur à base duquel les éléments semi-conducteurs sont formés.

Selon une possibilité de mise en oeuvre de ce procédé pour laquelle les éléments semi-conducteurs sont à base d'un matériau semi-conducteur dopé, la modification de l'arrangement atomique du matériau semi-conducteur peut comprendre une activation de dopants dans ce matériau semi-conducteur.

Ainsi, les éléments semi-conducteurs peuvent être initialement amorphes et le recuit permet alors de les rendre cristallin (polycristallin ou monocristallin).

Les éléments semi-conducteurs peuvent être initialement amorphes et dopés, le recuit permettant alors de les rendre cristallin et de réaliser une activation des dopants en les intégrant à la maille cristalline du matériau.

Les éléments semi-conducteurs peuvent être initialement cristallins et dopés, le recuit permettant alors de réaliser une activation des dopants en les intégrant à la maille cristalline du matériau.

Selon une possibilité de mise en oeuvre, la zone de protection réfléchissante est disposée sur les composants et les éléments semi-conducteurs sont disposés sur la zone de protection réfléchissante, de sorte que lors de l'exposition au laser la zone de protection réfléchissante est située entre les éléments semi-conducteurs et les composants, et permet de réfléchir le rayonnement lumineux sur les éléments semi-conducteurs tout en protégeant les composants de ce rayonnement.

Selon une autre possibilité de mise en oeuvre, les éléments peuvent être disposés sous la zone de protection et au moins en partie en regard d'ouvertures pratiquées dans la zone de protection.

Dans ce cas, les éléments semi-conducteurs peuvent participer à la protection des composants en absorbant le rayonnement lumineux.

En variante, les éléments semi-conducteurs peuvent être disposés dans des ouvertures pratiquées dans la zone de protection réfléchissante.

Dans ce cas également, les éléments semi-conducteurs peuvent participer à la protection des composants en absorbant le rayonnement lumineux.

Selon une possibilité de mise en oeuvre du procédé, la zone de protection réfléchissante peut être disposée de manière provisoire sur le support.

Ainsi, lorsque les éléments à cristalliser ou recristalliser ne reposent pas sur la zone de protection réfléchissante et sont situés dans des ouvertures réalisées dans cette zone ou au fond d'ouvertures réalisées dans cette zone de protection réfléchissante, on peut, après l'étape d'exposition des éléments au laser, retirer la zone de protection réfléchissante du support.

Selon une possibilité de mise en oeuvre du procédé, les éléments à l'étape a) peuvent être formés préalablement par structuration d'une couche de matériau semi-conducteur.

Un mode de réalisation de la présente invention prévoit une structure comprenant : un support doté d'un ou plusieurs composants et d'un ou plusieurs éléments semi-conducteurs formés au-dessus des composants, la structure comprenant en outre au moins une zone de protection réfléchissante située au-dessus des composants, la zone réfléchissante étant un cristal photonique et configurée pour réfléchir un rayonnement dans une gamme de longueur d'ondes donnée, la zone de protection étant formée d'un empilement comportant une alternance de couches à base d'au moins un premier matériau diélectrique et de couches à base d'au moins un deuxième matériau diélectrique, la zone de protection réfléchissante étant agencée par rapport aux éléments semi-conducteurs et aux composants, de manière à réfléchir le rayonnement lumineux et protéger les composants de ce rayonnement.

La zone de protection réfléchissante peut être formée sur ou au-dessus des composants, les éléments semi-conducteurs étant formés sur ou au-dessus de la zone de protection réfléchissante.

Une variante prévoit des éléments disposés au moins en partie sous la zone de protection et au moins en partie en regard des ouvertures.

Une autre variante de réalisation prévoit des éléments semi-conducteurs étant disposés dans les ouvertures d'une zone de protection réfléchissante

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de procédé et de dispositif pour modifier l'arrangement atomique d'éléments semi-conducteurs et en particulier réaliser une cristallisation ou recristallisation d'éléments semi-conducteurs ou une activation de dopants dans des éléments semi-conducteurs, ces éléments étant disposés sur un support doté de composants, le support étant protégé par une zone réfléchissante sous forme d'un cristal photonique tel qu'un miroir de Bragg lors d'une exposition des éléments à un rayonnement laser,
- la figure 2 donne une courbe de réflectivité d'un empilement formant le miroir de Bragg en fonction du nombre de couches de cet empilement,
- la figure 3 illustre un phénomène d'absorption lumineuse d'un élément semi-conducteur soumis à un rayonnement laser et disposé au-dessus d'une zone réfléchissante telle que mise en oeuvre dans un procédé et un dispositif suivant l'invention,
- la figure 4 illustre un autre mode de réalisation dans lequel les éléments semi-conducteurs exposés au laser sont disposés au fond d'ouvertures prévues dans la zone réfléchissante,
- la figure 5 illustre une étape de retrait de la zone réfléchissante après exposition des éléments au rayonnement laser,
- la figure 6 illustre un autre mode de réalisation dans lequel les éléments semi-conducteurs sont disposés dans des ouvertures traversant la zone réfléchissante,
- la figure 7 illustre un procédé et de dispositif pour réaliser une modification de l'arrangement atomique d'éléments semi-conducteurs disposés sur un support doté de composants, le support étant protégé par une zone réfléchissante métallique, n'étant pas le sujet de la présente invention,
- la figure 8 donne une courbe de réflectivité d'une couche réfléchissante à base d'Aluminium en fonction de son épaisseur,
- la figure 9 donne un exemple de courbe d'intensité de rayonnement laser traversant une couche semi-conductrice amorphe à base de Si en fonction de son épaisseur,
- les figures 10A-10C illustrent un exemple de procédé de réalisation d'une structure suivant l'invention, préalablement à une exposition à un laser,
- les figures 11A-11B illustrent un autre procédé de réalisation d'une structure suivant l'invention,
- les figures 12A-12B illustrent des exemples de zones réfléchissantes formant respectivement un cristal photonique 2D et un cristal photonique 3D,
- les figures 13A-13D illustrent un exemple de procédé de réalisation d'une zone réfléchissante sous forme de cristal photonique 2D ou 3D,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « sur », « sous », « au-dessus », au-dessous », « au fond », s'appliquent en considérant que la structure est orientée de la façon illustrée dans les figures.

### EXPOSÉ DÉTAILLÉ DE MODES DE RÉALISATION PARTICULIERS

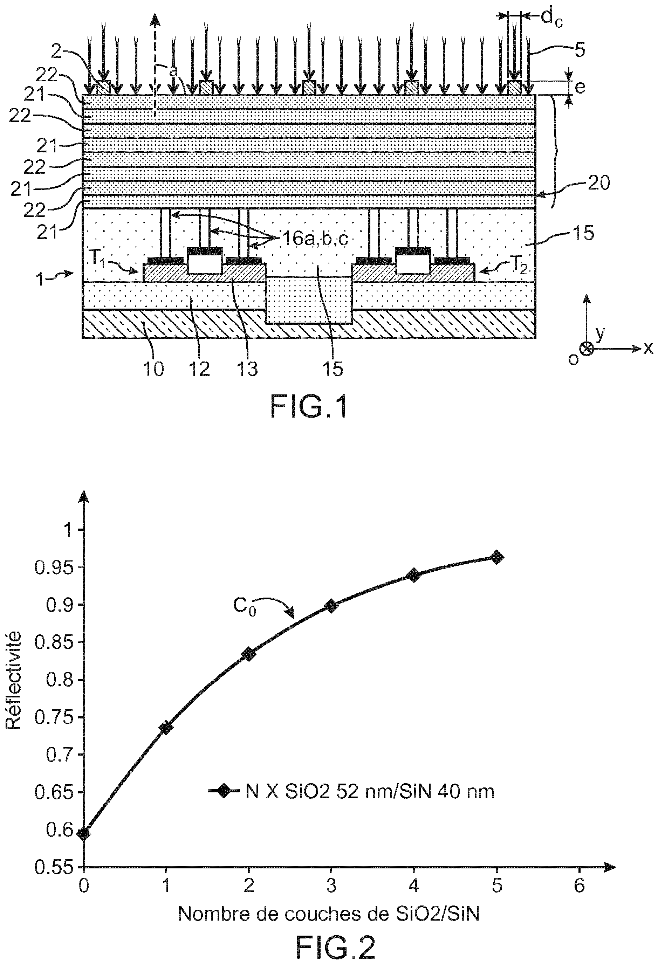

Un exemple de procédé de modification de l'arrangement atomique d'éléments semi-conducteurs 2 par exposition à un rayonnement lumineux, est illustré sur la figure 1. Dans cet exemple de réalisation la source de rayonnement lumineux utilisée est une source laser.

En fonction du matériau semi-conducteur à base duquel les éléments 2 sont formés, cette modification de l'arrangement atomique peut consister par exemple en une cristallisation ou une recristallisation du matériau semi-conducteur à base duquel les éléments semi-conducteurs 2 sont formés ou une activation de dopants dans ce matériau semi-conducteur, ou à la fois une cristallisation et une activation de dopants.

Les éléments semi-conducteurs 2 peuvent être à base d'un matériau amorphe ou rendu amorphe, tel que par exemple du Si amorphe que l'on expose au laser 5 pour lui conférer ou lui redonner une structure cristalline.

Dans ce cas, lorsque par exemple les éléments semi-conducteurs 2 sont à base de silicium amorphe dopé au bore ou au phosphore une activation de dopants peut être réalisée à une température de l'ordre de 900°C, tandis que la recristallisation du silicium amorphe s'effectue à une température de l'ordre de 600°C. Pour cet exemple de matériau, la mise en oeuvre d'une activation de dopants implique donc une cristallisation ou une recristallisation.

En variante, on peut utiliser le laser 5 uniquement pour effectuer activation de dopants, les éléments semi-conducteurs 2 étant dans ce cas à base de matériau semi-conducteur cristallin. Lorsque par exemple les éléments semi-conducteurs 2 sont à base de silicium monocristallin dopé au bore ou au phosphore, une activation de dopants à une température de l'ordre de 900° C n'implique pas nécessairement une modification de la structure cristalline du silicium monocristallin.

Selon une autre variante, les éléments semi-conducteurs 2 peuvent comporter une épaisseur de matériau amorphe et une épaisseur de matériau semi-conducteur cristallin.

Les éléments semi-conducteurs 2 dont on souhaite modifier l'arrangement atomique ont une dimension critique dc (mesurée parallèlement à un plan [O ; x ; y] d'un repère orthogonal [O ; x ; y ; z]) encore appelée largeur qui peut être comprise par exemple entre 1 nm et 10 µm.

Les éléments 2 ont également une épaisseur (mesurée parallèlement à l'axe z du repère orthogonal [O ; x ; y ; z]) encore appelée hauteur qui peut être comprise par exemple entre 1 nm et 1 µm. Des éléments 2 d'épaisseur supérieure à 30 nm peuvent être avantageusement cristallisés ou recristallisés ou subir une activation de dopants en absorbant la majorité du faisceau laser.

Les éléments 2 peuvent avoir été formés par structuration d'une couche de matériau semi-conducteur, cette couche pouvant avoir été formée par report sur un support.

les éléments semi-conducteurs 2 peuvent appartenir à une partie active d'un dispositif électronique, par exemple être destinés à former des canaux de transistors, ou d'un système électromécanique ou d'un capteur électrochimique ou photonique.

La source laser 5 employée peut par exemple émettre dans le domaine UV à une longueur d'onde par exemple de l'ordre de 308 nm. Selon un autre exemple, un laser de type Nd-YAG (acronyme du nom anglais : Neodymium-doped Yttrium Aluminium Garnet) émettant à une longueur d'onde par exemple de l'ordre de 532 nm peut être utilisé.

Le rayonnement lumineux a une incidence selon un angle α non-nul, par exemple de 90° avec le plan principal d'un support 1 (le plan principal du support étant défini comme un plan passant par ce dernier et parallèle au plan [O;x;y] du repère orthogonal [O;x;y;z]) sur lequel les éléments semi-conducteurs 2 sont disposés. Cet angle α peut être avantageusement modulé afin d'améliorer la recristallisation.

Les éléments semi-conducteurs 2 reposent sur un support 1 doté d'un ou plusieurs composants électroniques et/ou électromécaniques que l'on souhaite protéger du rayonnement laser 5. Pour cela, une zone réfléchissante 20 est prévue sur les composants. Dans l'exemple de réalisation de la figure 1, la zone réfléchissante 20 est disposée sous les éléments 2 semi-conducteurs.

Le support 1 peut être par exemple un dispositif microélectronique doté de composants électroniques tels que des transistors T₁, T₂ formés sur un substrat 10 qui peut être de type semi-conducteur sur isolant, par exemple de type SOI (SOI pour « silicon on insulator » ou « silicium sur isolant »). Le substrat comprend ainsi une couche de support semi-conductrice, qui peut être à base de Si, une couche isolante 11, par exemple à base d'oxyde de silicium, située sur et en contact avec la couche de support 10, la couche isolante 11 étant par exemple de type BOX (BOX pour « Buried Oxide ») et recouverte d'une couche semi conductrice 12 dite « superficielle » dans laquelle les zones de canal respectives des transistors et éventuellement une partie de leurs régions de source et de drain est réalisée. Les transistors T₁, T₂ peuvent être recouverts d'une couche isolante 15 par exemple à base de SiO₂, à travers laquelle des zones 16a, 16b, 16c de prise de contact sur les régions de source, de grille, et de drain des transistors T₁, T₂ sont formées. La couche isolante 15 est dans cet exemple de réalisation elle-même recouverte de la zone réfléchissante 20. Cette zone réfléchissante 20 est configurée pour réfléchir le rayonnement lumineux laser 5, dont la longueur d'onde peut être par exemple de l'ordre de 308 nm ou de 532 nm, ce qui permet d'améliorer la cristallisation ou la recristallisation des éléments 2 disposés sur cette dernière. La zone réfléchissante 20 a une réflectivité élevée, en particulier d'au moins 70% permettant également de protéger du rayonnement 5 les transistors T₁ et T₂ situés sous cette zone.

Dans cet exemple de réalisation particulier, la zone réfléchissante 20 disposée entre les éléments à cristalliser ou recristalliser et le ou les composants à protéger comprend un empilement de couches de matériaux 21, 22 d'indices de réfraction différents et réparties selon un agencement périodique. L'agencement périodique de couches 21, 22 forme un cristal photonique de type miroir de Bragg.

L'empilement comprend k (avec k un entier supérieur à 1) couches d'un premier matériau 21 ayant un premier indice n₁ de réfraction et m (avec m un entier supérieur à 1) couches d'un deuxième matériau 22 ayant un deuxième indice n₂ de réfraction. Cet empilement peut être en particulier formé d'une alternance de couches à base du premier matériau 21 et de couches à base du deuxième matériau 22.

Le premier matériau 21 peut être un avantageusement diélectrique tel que par exemple du Si₃N₄ tandis que le deuxième matériau 22 peut être également avantageusement un diélectrique tel que par exemple du SiO₂. Lorsque les couches de cet empilement sont choisies à base de matériau diélectrique, cela permet d'éviter la formation de capacités parasites et de favoriser l'introduction d'éléments d'interconnexion (non représentés sur la figure 1) traversant cette zone de protection réfléchissante. Un tel mode de réalisation est avantageux notamment lorsque les structures semi-conductrices sont disposées à un niveau supérieur communément appelé de « back end » d'un dispositif CMOS.

Les couches à base du premier matériau diélectrique 21 et celles à base du deuxième matériau diélectrique 22 peuvent avoir une épaisseur comprise par exemple entre 1 nm et 10 µm.

Le nombre de couches et les épaisseurs respectives des couches de matériaux 21, 22, est ainsi ajusté en fonction de la réflectivité désirée, celle-ci augmentant avec le nombre de couches de matériaux 21, 22.

L'exemple de courbe C₀ donnée sur la figure 2 donne une évolution de la réflectivité à une longueur d'onde de 308 nm en fonction du nombre N de couches de SiO₂ d'épaisseur de l'ordre de 52 nm et de couches de SiN de l'ordre de 40 nm selon un empilement tel qu'illustré sur la figure 1. Selon cette courbe C₀ à partir d'un nombre N=5, un miroir de Bragg avec un coefficient de réflectivité de l'ordre de 0.95 peut être avantageusement mis en oeuvre.

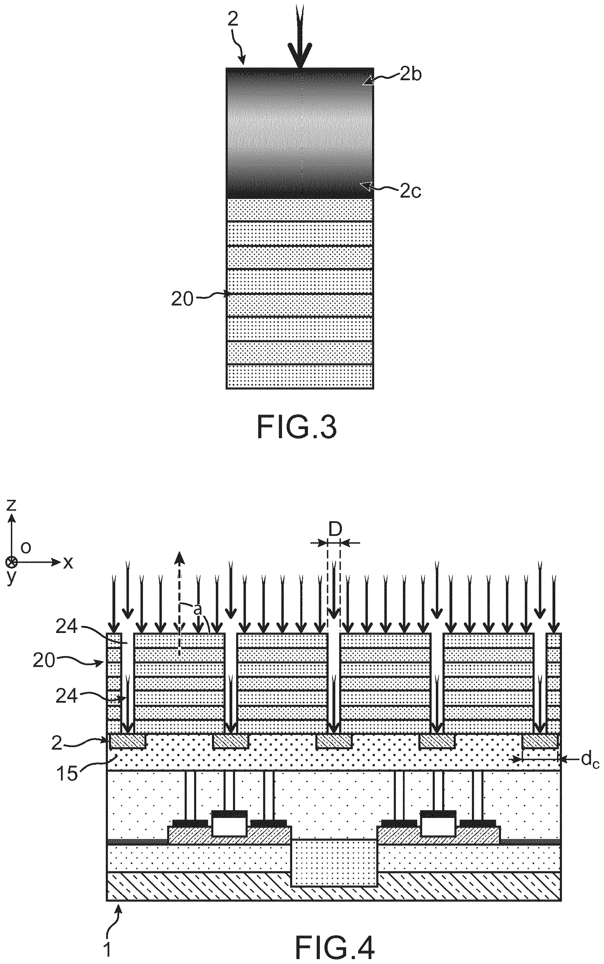

Avec un tel dispositif, l'absorption optique (illustrée sur la figure 3 par des zones denses sur un élément semi-conducteur 2) dans une zone supérieure 2b des éléments 2 est de l'ordre de 1-Rc avec Rc la réflectance des éléments 2, tandis que dans une zone inférieure 2c des éléments 2 située contre la zone réfléchissante 20, l'absorption optique est de l'ordre de 1-Rc-Tm avec Tm la transmittance de la zone réfléchissante 20 qui est très faible, ce qui permet d'augmenter l'absorption du rayonnement laser par les éléments 2 et de favoriser ainsi leur recristallisation.

Dans l'exemple de réalisation de la figure 1, les éléments semi-conducteurs sont formés sur et en contact de la zone réfléchissante. En variante, une ou plusieurs couches d'interface peuvent être prévues entre la zone réfléchissante 20 et les éléments semi-conducteurs 2.

Un autre agencement de la zone de protection 20 et des éléments semi-conducteurs 2 est donné sur la figure 4. Les éléments 2 semi-conducteurs sont dans cet exemple disposés sous la zone réfléchissante 20 de protection et dévoilées par des ouvertures 24 prévues à travers cette zone 20. Les ouvertures 24 pratiquées dans l'empilement de couches de matériau diélectrique 21, 22 peuvent avoir un diamètre D (mesuré parallèlement à un plan [O ;x ;y] d'un repère orthogonal [O ;x ;y ;z] sur la figure 4) qui peut être compris par exemple entre 10 nm et 100 µm et peut être prévu inférieur à la dimension critique dc des éléments 2.

Les éléments semi-conducteurs 2 situés au fond des ouvertures 24 peuvent être répartis sur la couche isolante 15 et éventuellement partiellement dans cette couche isolante 15 recouvrant les transistors T₁, T₂.

Dans cette configuration, les éléments 2 semi-conducteurs sont partiellement encapsulés, ce qui peut permettre d'éviter une modification de leur morphologie lorsque le recuit de cristallisation ou de recristallisation ou d'activation de dopants atteint une température importante en particulier proche de la température de fusion du matériau semi-conducteur.

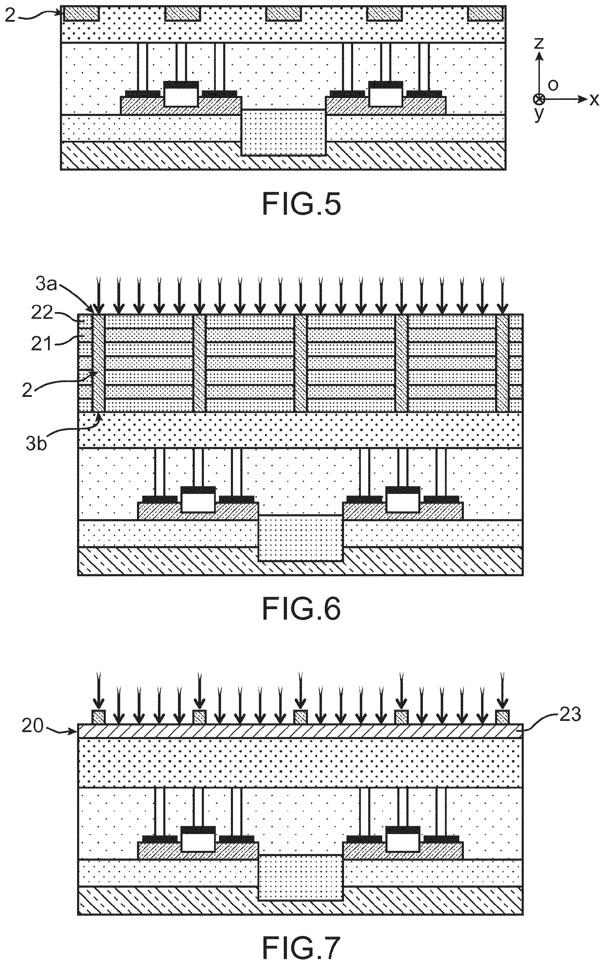

Dans cet exemple de réalisation, la zone réfléchissante 20 peut être disposée de manière provisoire sur les éléments 2 et retirée une fois la cristallisation par laser réalisée (figure 5). Un tel retrait peut être effectué par exemple par polissage CMP puis gravure humide.

La figure 6 illustre un autre exemple d'agencement dans lequel les éléments 2 semi-conducteurs sont cette fois disposés dans des ouvertures 24 situées dans la zone réfléchissante 20 de protection et traversant cette dernière.

Les éléments 2 remplissant les ouvertures 24 comportent une extrémité 3a débouchant sur la face supérieure de l'empilement de couches diélectriques 21, 22, qui est exposée au rayonnement laser 5. Une autre extrémité 3b des éléments semi-conducteurs débouche au niveau de la face inférieure de l'empilement et peut être connectée à une zone de contact ou de connexion (non représentée) de composants intégrés au support.

Dans cet exemple de réalisation, les éléments semi-conducteurs 2 peuvent avoir une forme de colonne ou de tige verticale et peuvent être destinés à former des éléments de conduction verticaux. Ces éléments de conduction verticaux peuvent par exemple réaliser des connexions communément appelés vias pour un dispositif 3D monolithique, ou encore des canaux de transistors.

Dans cette configuration comme dans celle précédemment décrite en liaison avec la figure 4, une partie du rayonnement laser pénétrant à travers les ouvertures 24, est absorbée par les éléments 2 qui servent alors également de protection aux transistors T₁, T₂ vis-à-vis du rayonnement laser 5.

Une configuration alternative, n'étant pas le sujet de la présente invention, prévoit une zone réfléchissante 20 formée d'une fine couche réfléchissante à base d'un matériau métallique 23 ayant une réflectivité élevée vis-à-vis du rayonnement laser. L'épaisseur et le matériau de la fine couche réfléchissante sont choisis de manière à lui conférer une réflectivité en particulier supérieure à 70%.

Ce matériau métallique 23 peut être par exemple de l'Aluminium (Al) ou du Rhodium (Rh) ou un alliage métallique par exemple à base d'Aluminium et de Cuivre.

Pour une source laser 5 émettant à 308 nm, une couche métallique à base d'Al et d'épaisseur de l'ordre de 50 nm peut par exemple avoir une réflectivité de l'ordre de 93 %, tandis qu'une couche métallique de même épaisseur et à base d'AICu peut avoir une réflectivité par exemple de l'ordre 91 % et qu'une couche de Rh peut avoir une réflectivité par exemple de l'ordre 74 %. Une telle couche peut être formée par exemple par pulvérisation à une température inférieure à 300 °C.

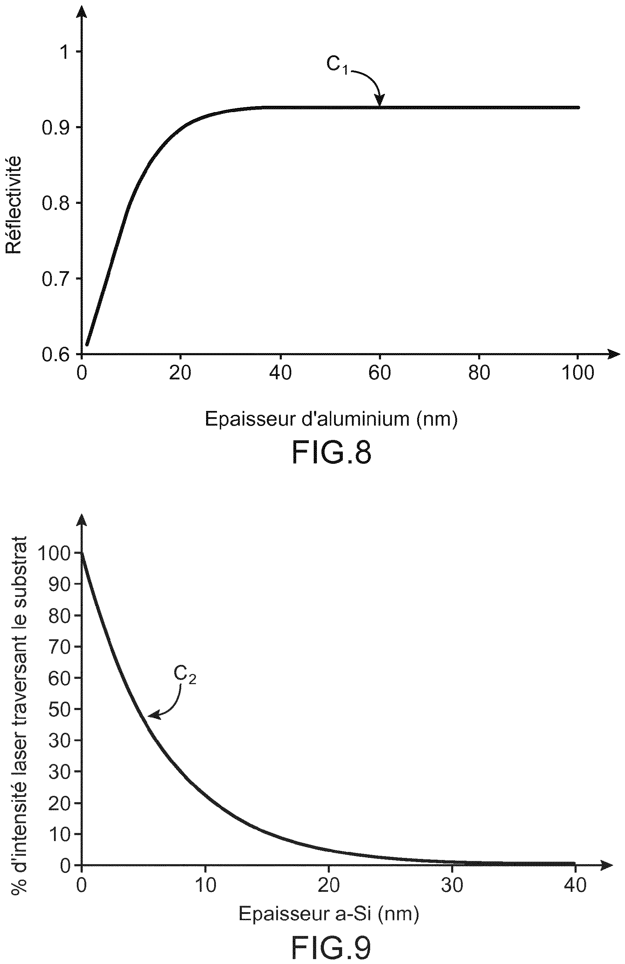

La figure 9 donne un exemple de courbe C₁ de réflectivité d'une couche à base d'Aluminium, en fonction de son épaisseur, pour un rayonnement laser émettant à une longueur d'onde de 308 nm. Cette courbe C₁ montre qu'au-delà d'une épaisseur de l'ordre de 30 nm, une réflectivité supérieure à 90% peut être obtenue.

L'exposition à un laser 5 selon l'un ou l'autre des agencements de zone réfléchissante 20 qui viennent d'être décrits peut être également mise en oeuvre pour réaliser une activation de dopants, lorsque les éléments semi-conducteurs 2 sont dopés. Une telle activation peut être réalisée par exemple pour former des jonctions dans les éléments semi-conducteurs 2.

Dans l'un ou l'autre des exemples des modes de réalisation qui ont été décrits précédemment, des éléments semi-conducteurs sont formés par structuration d'une couche.

En variante, on peut réaliser une recristallisation ou une activation dite « pleine plaque », l'élément semi-conducteur que l'on recristallise ou pour lequel on effectue un activation de dopants étant alors une couche qui n'est pas encore structurée et peut être éventuellement structurée ultérieurement.

La figure 9 donne un exemple de courbe C₂ de pourcentage d'énergie laser de longueur d'onde de 308 nm traversant une couche de Si amorphe en fonction de son épaisseur. Cette courbe montre l'intérêt de mettre en oeuvre une zone réfléchissante 20 sous une telle couche puisqu'au-delà d'une certaine épaisseur de la couche de Si, l'énergie laser n'est presque pas absorbée et transmise à des couches sous-jacentes.

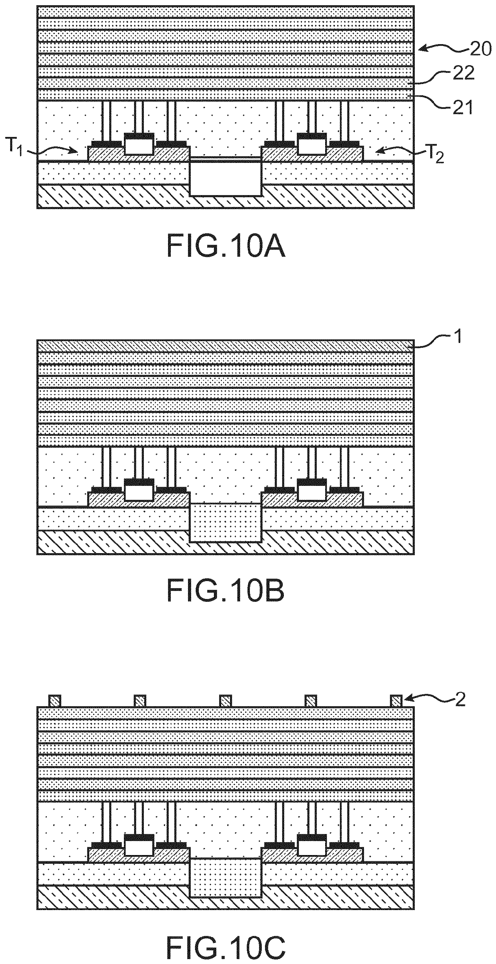

Un exemple de procédé de réalisation d'une structure telle qu'illustrée sur la figure 1 va à présent être donné en liaison avec les figure 10A-10C.

Le matériau de départ du procédé est dans cet exemple le dispositif microélectronique comportant les transistors T₁, T₂ formés sur le substrat 10 de type semi-conducteur sur isolant et recouverts par la couche isolante 15.

Sur cette couche isolante 15, on réalise tout d'abord la zone de protection 20 réfléchissante sous forme d'une alternance de couches à base du premier matériau diélectrique 21, par exemple du Si₃N₄, et de couches à base d'un deuxième matériau diélectrique 22 tel que par exemple du SiO₂ (figure 10A).

Pour cela, on met en oeuvre des dépôts successifs en utilisant par exemple une technique de type PECVD (pour « Plasma Enhanced Chemical Vapor Déposition » c'est-à-dire dépôt chimique en phase vapeur assisté par plasma) à basse température, par exemple inférieure à 300°C afin de conserver un faible budget thermique.

Ensuite, on forme une couche semi-conductrice 1 (figure 10B). Selon un exemple de réalisation particulier, dans le cas où la couche semi-conductrice 1 est à base de matériau cristallin, celle-ci peut être formée par report sur la zone de protection 20.

On forme ensuite des motifs dans cette couche semi-conductrice 1, par exemple par photolithographie puis gravure, de manière à réaliser les éléments semi-conducteurs 2 (figure 10C).

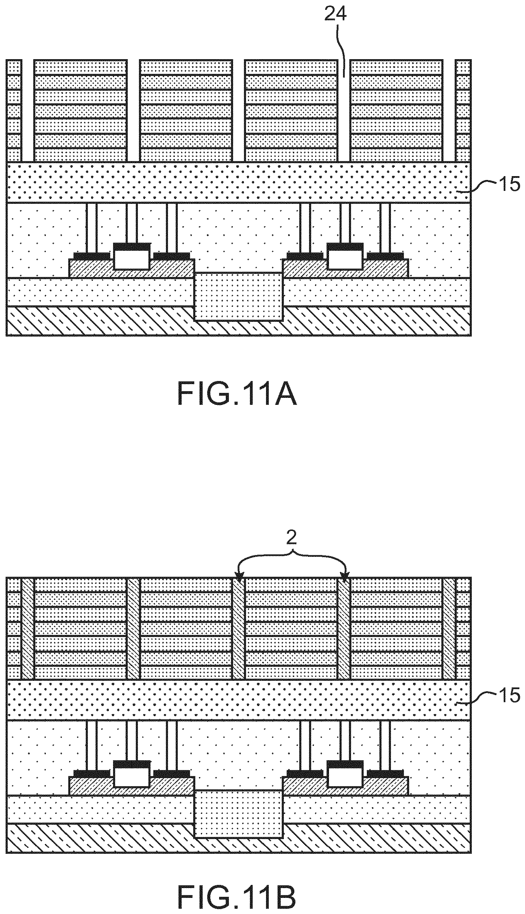

Une variante de cet exemple de procédé, permet de réaliser une structure telle qu'illustrée sur la figure 6. Pour cela, après l'étape de formation de l'empilement de couches diélectriques formant un miroir de Bragg, on peut pratiquer des ouvertures 24 traversant cet empilement et dont le fond dévoile la couche isolante 15 (figure 11A).

Ensuite, on remplit ces ouvertures 24 à l'aide de matériau semi-conducteur, afin de former des éléments semi-conducteurs 2 traversant l'empilement réalisant un miroir de Bragg. Puis, une planarisation, par exemple par CMP pour (« Chemical Mechanical Polishing ») peut être effectuée pour retirer le matériau semi-conducteur dépassant de l'embouchure des ouvertures 24 (figure 11B).

Selon une autre variante, on peut réaliser une structure telle qu'illustrée sur la figure 4, en formant des trous dans la couche isolante 15, puis remplissant ces trous par un matériau semi-conducteur, de manière à former les éléments semi-conducteurs 2 (figure 5).

Une variante de mise en oeuvre du dispositif illustré sur la figure 1 prévoit de remplacer la zone réfléchissante 20 formant un cristal photonique de type miroir de Bragg par un autre type de cristal photonique comportant un réseau en 2 ou en 3 dimensions.

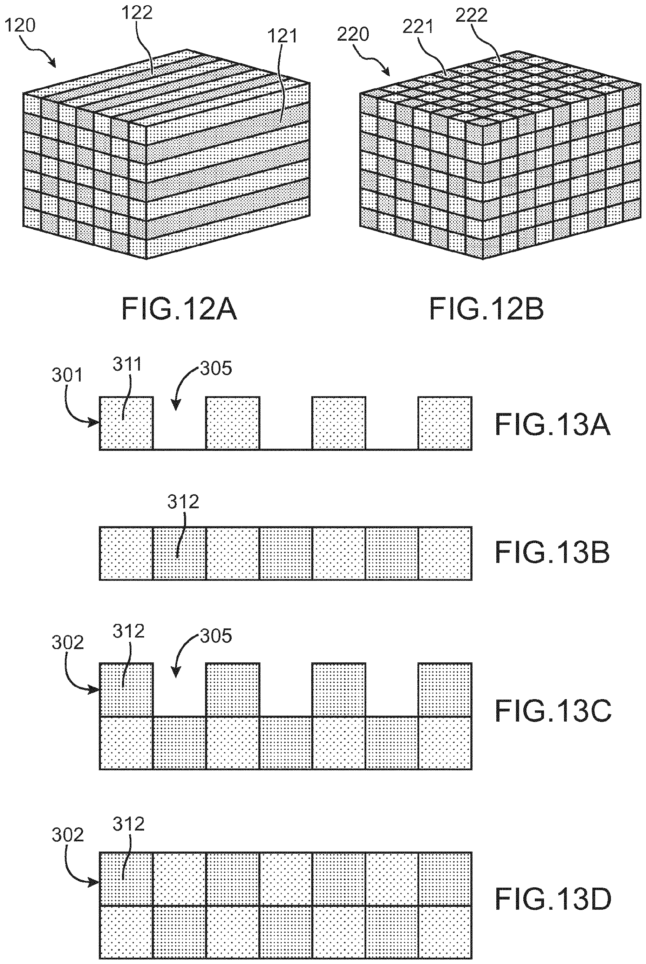

Un exemple de réalisation de zone réfléchissante 20 formant un cristal photonique est illustré sur la figure 12A. Le cristal photonique peut comporte ici un réseau périodique d'éléments parallélépipédiques 121, 122 à base respectivement d'un premier matériau et d'un deuxième matériau d'indice de réfraction différent de celui du premier matériau et qui sont alternativement répartis alternativement sur 2 dimensions.

On forme ici un empilement de barreaux parallélépipédiques juxtaposés répartis de manière à obtenir une zone réfléchissante ayant une variation périodique d'indice de réfraction dans 2 directions.

Selon un autre exemple de réalisation illustré sur la figure 12B, le cristal photonique peut comporter un réseau périodique d'éléments 221, 222 cubiques à base respectivement d'un premier matériau et d'un deuxième matériau d'indice de réfraction différent de celui du premier matériau, les éléments cubiques 221, 222 étant répartis sur 3 dimensions. On forme ici un empilement d'éléments cubiques juxtaposés répartis de manière à obtenir une zone réfléchissante ayant une variation périodique d'indice de réfraction dans 3 directions.

Un cristal photonique formé d'un réseau 2D ou 3D permet d'obtenir une réflectivité sur une plus large bande qu'un réseau 1D de type miroir de Bragg. Cela peut permettre d'avoir une tolérance sur la précision avec laquelle l'angle d'incidence du laser 5 est réglé.

Un exemple de méthode pour former un cristal photonique 2D tel qu'illustré sur la figure 12A ou pour former un cristal photonique 3D tel qu'illustré sur la figure 12B va à présent être décrit en liaison avec les figures 13A-13C.

On forme tout d'abord une première couche 301 à base d'un matériau 311 ayant un premier indice de réfraction n₁, par exemple un matériau diélectrique tel que du SiN déposé par PECVD.

On réalise ensuite des trous 305 dans cette première couche 301 par exemple en à l'aide d'une technique de lithographie à ultraviolet profond (DUV) ou à de lithographie à l'aide d'un faisceau d'électrons ou par exemple à l'aide d'un moule d'embossage selon une technique communément appelée de « nanoimprint » (figure 13A).

Pour réaliser un cristal photonique 2D, les trous 305 peuvent être par exemple sous forme de tranchées parallélépipédiques parallèles entre elles tandis que pour un cristal photonique 3D, les trous peuvent être répartis sur deux dimensions et peuvent par exemple avoir une forme cubique.

On effectue ensuite un remplissage des trous par un deuxième matériau 312 ayant un deuxième indice n₂ de réfraction, par exemple un matériau diélectrique tel que du SiO₂. Pour retirer le deuxième matériau 312 qui se trouve éventuellement en excès et dépasse de l'embouchure des trous 305, une gravure ou un polissage de type CMP peut être ensuite effectué (figure 13B).

On forme ensuite une deuxième couche 302 à base du deuxième matériau 312 (figure 13C).

On réalise ensuite des trous 305 dans cette deuxième couche 302 (figure 13C).

On remplit ensuite les trous par le premier matériau (figure 13D).

On peut ensuite réitérer les étapes qui viennent d'être décrites un nombre de fois donné en fonction du pas que l'on souhaite donner au réseau.

En variante, on peut réaliser un cristal photonique 2D, formé d'une seule couche pour permettre avantageusement de limiter l'encombrement de la zone réfléchissante.

Selon une variante de la méthode de réalisation du cristal photonique formé d'un réseau 2D ou 3D, chaque étage peut être formé par une couche de copolymère bloc à bloc que l'on rapporte.

La mise en oeuvre de couches dites « auto-assemblées » permet de s'affranchir des méthodes conventionnelles de lithographie avec un masque. Un procédé de fabrication utilisant des couches « auto-assemblées » est généralement qualifiée de DSA pour « Directed Self-Assembly ».

Un procédé selon l'un ou l'autre des exemples précédemment décrits peut être réalisé pour fabriquer des mémoires embarquées ou des capteurs embarqués.

## Revendications

1. Procédé de modification de l'arrangement atomique d'éléments semi-conducteurs par recuit, comprenant des étapes consistant à :
a) prévoir un support (10-11-12-15) comportant un ou plusieurs éléments semi-conducteurs dont on veut modifier l'arrangement atomique, le support étant doté en outre d'un ou plusieurs composants (T₁, T₂) et d'au moins une zone de protection réfléchissante (20), la zone de protection réfléchissante (20) étant un cristal photonique et configurée de manière à réfléchir un rayonnement lumineux dans une gamme de longueur d'ondes donnée, la zone de protection étant formée d'un empilement comportant une alternance de couches à base d'au moins un premier matériau diélectrique et de couches à base d'au moins un deuxième matériau diélectrique,
b) exposer le ou les éléments (2) à un rayonnement (5) émettant dans ladite gamme de longueurs d'ondes donnée de manière à effectuer un recuit de(s)dit(s) élément(s), la zone de protection réfléchissante étant agencée sur le support par rapport au(x)dit(s) élément(s) et au(x) composant(s) de manière à réfléchir le rayonnement et protéger le ou les composants de ce rayonnement, tout en permettant l'exposition du ou des éléments au rayonnement.

2. Procédé selon la revendication 1, dans lequel la modification de l'arrangement atomique des éléments semi-conducteurs (2) comprend une cristallisation ou recristallisation d'un matériau semi-conducteur à base duquel les éléments semi-conducteurs sont formés.

3. Procédé selon la revendication 1 ou 2, dans lequel les éléments semi-conducteurs (2) sont à base d'un matériau semi-conducteur dopé, la modification de l'arrangement atomique du matériau semi-conducteur comprenant une activation de dopants dans ce matériau semi-conducteur.

4. Procédé selon l'une des revendications 1 à 3, dans lequel la zone de protection réfléchissante (20) est configurée pour réfléchir au moins 70% et avantageusement au moins 90% du rayonnement lumineux.

5. Procédé selon l'une des revendications 1 à 4, dans lequel la zone de protection réfléchissante (20) est disposée au-dessus des composants et dans lequel les éléments (2) sont disposés au-dessus de la zone de protection réfléchissante, de sorte que lors de l'exposition au rayonnement lumineux (5), la zone de protection réfléchissante est située entre les composants (T₁, T₂) et les éléments (2).

6. Procédé selon l'une des revendications 1 à 4, dans lequel la zone de protection réfléchissante (20) comporte des ouvertures (24), les éléments (2) étant disposés au moins en partie sous la zone de protection et au moins en partie en regard des ouvertures (24).

7. Procédé selon l'une des revendications 1 à 4, dans lequel la zone de protection réfléchissante (20) comporte des ouvertures (24), les éléments (2) étant disposés dans les ouvertures (24).

8. Procédé selon l'une des revendications 6 ou 7, comprenant après l'étape b) d'exposition, une étape de retrait de la zone de protection réfléchissante (20) du support (10-11-12-15).

9. Procédé selon l'une des revendications 1 à 8, dans lequel la zone de protection réfléchissante (20) comprend un empilement de couches formant un miroir de Bragg.

10. Procédé selon l'une des revendications 1 à 9, dans lequel les éléments semi-conducteurs (2) à l'étape a) sont formés préalablement par structuration d'une couche de matériau semi-conducteur.

11. Structure comprenant : un support doté d'un ou plusieurs composants et d'un ou plusieurs éléments semi-conducteurs (2) formés au-dessus des composants, la structure comprenant en outre au moins une zone de protection réfléchissante (20) située au-dessus des composants (T1, T2), la zone réfléchissante étant un cristal photonique et configurée pour réfléchir un rayonnement dans une gamme de longueur d'ondes donnée, la zone de protection étant formée d'un empilement comportant une alternance de couches à base d'au moins ün premier matériau diélectrique et de couches à base d'au moins un deuxième matériau diélectrique, la zone de protection réfléchissante étant agencée par rapport aux éléments semi-conducteurs et aux composants, de manière à réfléchir le rayonnement lumineux et protéger les composants de ce rayonnement.

12. Structure selon la revendication 11, dans lequel la zone de protection réfléchissante (20) est formée au-dessus des composants et dans lequel les éléments (2) sont formés au-dessus de la zone de protection réfléchissante.

13. Structure selon la revendication 11, dans lequel la zone de protection réfléchissante (20) comporte des ouvertures (24), les éléments (2) étant disposés au moins en partie sous la zone de protection et au moins en partie en regard des ouvertures.

14. Structure selon la revendication 11, dans lequel la zone de protection réfléchissante (20) comporte des ouvertures (20), les éléments (2) étant disposés dans les ouvertures.

## Patentansprüche

1. Verfahren zur Modifizierung der atomaren Anordnung von Halbleiterelementen durch Ausglühen, welches die folgenden Schritte umfasst:
a) Vorsehen eines Trägers (10-11-12-15), der ein oder mehrere Halbleiterelemente umfasst, deren atomare Anordnung modifiziert werden soll, wobei der Träger ferner eine oder mehrere Komponenten (T₁, T₂) aufweist, und wenigstens eine reflektierende Schutzzone (20), wobei die reflektierende Schutzzone (20) ein photonischer Kristall ist und derart ausgebildet wird, dass eine Lichtstrahlung in einem gegebenen Wellenlängenbereich reflektiert wird, wobei die Schutzzone aus einem Stapel gebildet wird, welcher Schichten auf der Basis wenigstens eines ersten dielektrischen Materials und Schichten auf der Basis wenigstens eines zweiten dielektrischen Materials im Wechsel umfasst,
b) Strahlenexposition (5) des Elements oder der Elemente (2) in dem gegebenen Wellenlängenbereich derart, dass ein Ausglühen des Elements/der Elemente stattfindet, wobei die reflektierende Schutzzone im Verhältnis zu dem Element/den Elementen und der Komponente/den Komponenten auf dem Träger derart angeordnet ist, dass die Strahlung reflektiert wird und die Komponente oder die Komponenten vor dieser Strahlung geschützt werden, wobei gleichzeitig die Strahlenexposition des Elements oder der Elemente möglich ist.

2. Verfahren nach Anspruch 1, bei welchem die Modifizierung der atomaren Anordnung der Halbleiterelemente (2) eine Kristallisation oder Re-Kristallisation eines Halbleitermaterials umfasst, auf dessen Basis die Halbleiterelemente gebildet werden.

3. Verfahren nach Anspruch 1 oder 2, bei welchem die Halbleiterelemente (2) auf einem dotierten Halbleitermaterial basieren, wobei die Modifizierung der atomaren Anordnung des Halbleitermaterials eine Aktivierung von Dotierstoffen in diesem Halbleitermaterial umfasst.

4. Verfahren nach einem der Ansprüche 1 bis 3, bei welchem die reflektierende Schutzzone (20) dazu ausgebildet wird, wenigstens 70%, vorteilhafterweise wenigstens 90% der Lichtstrahlung zu reflektieren.

5. Verfahren nach einem der Ansprüche 1 bis 4, bei welchem die reflektierende Schutzzone (20) über den Komponenten angeordnet wird, und bei welchem die Elemente (2) über der reflektierenden Schutzzone derart angeordnet werden, dass bei der Lichtstrahlenexposition (5) die reflektierende Schutzzone zwischen den Komponenten (T₁, T₂) und den Elementen (2) angeordnet wird.

6. Verfahren nach einem der Ansprüche 1 bis 4, bei welchem die reflektierende Schutzzone (20) Öffnungen (24) umfasst, wobei die Elemente (2) wenigstens teilweise unter der Schutzzone angeordnet werden und wenigstens teilweise den Öffnungen (24) zugewandt sind.

7. Verfahren nach einem der Ansprüche 1 bis 4, bei welchem die reflektierende Schutzzone (20) Öffnungen (24) umfasst, wobei die Elemente (2) in den Öffnungen (24) angeordnet werden.

8. Verfahren nach einem der Ansprüche 6 oder 7, welches nach Schritt b) der Exposition einen Schritt der Entfernung des Trägers (10-11-12-15) aus der reflektierenden Schutzzone (20) umfasst.

9. Verfahren nach einem der Ansprüche 1 bis 8, bei welchem die reflektierende Schutzzone (20) einen Stapel von Schichten umfasst, die einen Bragg-Spiegel bilden.

10. Verfahren nach einem der Ansprüche 1 bis 9, bei welchem die Halbleiterelemente (2) im Schritt a) zuvor durch Strukturierung einer Schicht eines Halbleitermaterials gebildet werden.

11. Struktur, welche umfasst: einen Träger, der mit einer oder mehreren Komponenten sowie mit einem oder mehreren über den Komponenten gebildeten Halbleiterelementen (2) versehen ist, wobei die Struktur ferner wenigstens eine reflektierende Schutzzone (20) umfasst, die über den Komponenten (T₁, T₂) angeordnet ist, wobei die reflektierende Zone ein photonischer Kristall ist und dazu ausgebildet ist, eine Lichtstrahlung in einem gegebenen Wellenlängenbereich zu reflektieren, wobei die Schutzzone aus einem Stapel gebildet ist, welcher Schichten auf der Basis wenigstens eines ersten dielektrischen Materials und Schichten auf der Basis wenigstens eines zweiten dielektrischen Materials im Wechsel umfasst, wobei die reflektierende Schutzzone im Verhältnis zu den Halbleiterelementen und den Komponenten derart angeordnet ist, dass die Lichtstrahlung reflektiert wird und die die Komponenten vor dieser Strahlung geschützt werden.

12. Struktur nach Anspruch 11, bei welcher die reflektierende Schutzzone (20) über den Komponenten gebildet ist und bei welcher die Elemente (2) über der reflektierenden Schutzzone gebildet sind.

13. Struktur nach Anspruch 11, bei welcher die reflektierende Schutzzone (20) Öffnungen (24) umfasst, wobei die Elemente (2) wenigstens teilweise unter der Schutzzone angeordnet sind und wenigstens teilweise den Öffnungen zugewandt sind.

14. Struktur nach Anspruch 11, bei welcher die reflektierende Schutzzone (20) Öffnungen (20) umfasst, wobei die Elemente (2) in den Öffnungen angeordnet sind.

## Claims

1. Method for modifying the atomic arrangement of semi-conducting elements by annealing, comprising the steps of:
a) providing a support (10-11-12-15) having one or more semi-conducting elements the atomic arrangement of which is desired to be modified, the support being further provided with one or more components (T₁, T₂) and with at least one reflective protective area (20), the reflective protective area (20) being a photonic crystal and configured so as to reflect a light radiation in a given wavelength range, the protective area (20) being formed by a stack having an alternation of layers based on at least a first dielectric material and of layers based on at least a second dielectric material;
b) exposing the element(s) (2) to a radiation (5) emitting in said given wavelength range so as to carry out annealing of said element(s), the reflective protective area being arranged on the support relative to said element(s) and to component(s) so as to reflect the radiation and protect the component(s) from this radiation, while allowing the exposure of the element(s) to the radiation.

2. Method according to claim 1, wherein modifying the atomic arrangement of the semi-conducting elements (2) comprises crystallizing or recrystallizing a semi-conducting material based on which the semi-conducting elements are formed.

3. Method according to claim 1 or 2, wherein the semi-conducting elements (2) are based on a doped semi-conducting material, modifying the atomic arrangement of the semi-conducting material comprising activating dopants in this semi-conducting material.

4. Method according to one of claims 1 or 2, wherein the reflective protective area (70) is configured to reflect at least 70% and advantageously at least 90% of the light radiation.

5. Method according to one of claims 1 to 4, wherein the reflective protective area (20) is disposed above the components and wherein the elements (2) are disposed above the reflective protective area, so that during exposure to light radiation (5), the reflective protective area is situated between the components (T₁, T₂) and the elements (2).

6. Method according to one of claims 1 to 5, wherein the reflective protective area (20) has openings (24), the elements (2) being disposed at least in part under the protective area and at least in part facing the openings (24).

7. Method according to one of claims 1 to 4, wherein the reflective protective area (20) has openings (24), the elements (2) being disposed in the openings (24).

8. Method according to claim 6 or 7, comprising, after the step b) of exposure, a step of removing the reflective protective area (20) from the support (10-11-12-15).

9. Method according to one of claims 1 to 8, wherein the reflective protective area (20) comprises a stack of layers forming a Bragg mirror.

10. Method according to one of claims 1 to 9, wherein the semi-conducting elements (2) in step a) are previously formed by structuring a semi-conducting material layer.

11. Structure comprising: a support provided with one or more components and one or more semi-conducting elements (2) formed above the components, the structure comprising at least one reflective protective area (20) situated above the components (T₁, T₂), the reflective area being a photonic crystal and configured to reflect a radiation in a given wavelength range, the protective area being formed by a stack having an alternation of layers based on at least a first dielectric material and of layers based on at least a second dielectric material, the reflective protective area being arranged relative to the semi-conducting elements and to the components, so as to reflect the light radiation and protect the components from this radiation.

12. Structure according to claim 11, wherein the reflective protective area (20) is formed above the components and wherein the elements (2) are formed above the reflective protective area.

13. The structure according to claim 11, wherein the reflective protective area (20) has openings (24), the elements (2) being disposed at least in part under the protective area and facing at least in part the openings.

14. The structure according to claim 11, wherein the reflective protective area (20) has openings (20), the elements (2) being disposed in the openings.
